# EUROPÄISCHE PATENTANMELDUNG

(11) **EP 3 389 019 A1**
(43) Veröffentlichungstag der Anmeldung: **17.10.2018**
(21) Anmeldenummer: 18156430.3
(22) Anmeldetag: 13.02.2018
(51) Int. Cl.: G06T 17/10, B62D 15/02, G06T 11/20

(54) **VORRICHTUNG UND VERFAHREN ZUR GEOMETRISCHEN KONSTRUKTION EINER VORHERGESAGTEN DURCH EIN FAHRZEUG BELEGTEN FLÄCHE**

(30) Priorität: 12.04.2017 DE 102017206345
(71) Anmelder: Continental Automotive GmbH, 30165 Hannover (DE)
(72) Erfinder: Selensky, Denis, 65936 Frankfurt (DE)
(74) Vertreter: Reuter, Andreas

(57) **Zusammenfassung**

Die vorliegende Erfindung betrifft eine Vorrichtung (100) zur geometrischen Konstruktion einer vorhergesagten durch ein Fahrzeug belegten Fläche, wobei die Vorrichtung (100) umfasst: eine Trajektoriezuordnungseinheit (10), die dazu ausgestaltet ist, basierend auf einer Liste von Fahrzeugscheitelpunkten (VV1, VV2, VV3, ..., VVn), die jeweils eine Position und eine Bewegungsrichtung eines Punkts (VBP) einer Karosserie (VB) eines Fahrzeugs (V) definieren, eine Fahrzeugtrajektorie bereitzustellen; eine Trajektorietransformationseinheit (20), die dazu ausgestaltet ist, eine Liste von Scheitelpunkten der äußersten Punkte (EPV1, EPV2, EPV3, ..., EPVn) zu berechnen, indem sie für eine gegebene Position des Fahrzeugs einen Punkt (VBP) der Karosserie (VB) mit dem kleinsten und/oder dem größten Wenderadius auswählt, und die dazu ausgestaltet ist, basierend auf der Liste von Scheitelpunkten der äußersten Punkte (EPV1, EPV2, EPV3, ..., EPVn) des Fahrzeugs (V) mehrere Eckentrajektorien bereitzustellen; und eine Lückenausräumeinheit (30) und eine Schnittpunktentfernungseinheit (40), die dazu ausgestaltet sind, basierend auf den mehreren Eckentrajektorien einen Belegungskorridor bereitzustellen, wobei die Lückenausräumeinheit (30) dazu ausgestaltet ist, aufeinanderfolgende Kurven der mehreren Eckentrajektorien zu verbinden, und wobei die Schnittpunktentfernungseinheit (40) dazu ausgestaltet ist, sich schneidende Kurven der mehreren Eckentrajektorien abzuschneiden.

## Beschreibung

### GEBIET DER ERFINDUNG

Die vorliegende Erfindung betrifft das Gebiet der rasterbasierten Vorhersage der Position und Belegungsfläche eines Objekts. Insbesondere betrifft die vorliegende Erfindung eine Vorrichtung und ein Verfahren zur geometrischen Konstruktion einer vorhergesagten durch ein Fahrzeug belegten Fläche.

### HINTERGRUND DER ERFINDUNG

Beim Berechnen und Visualisieren des vorhergesagten Belegungskorridors des Fahrzeugs mit einer auf einer komplexen Spline-Kurve basierenden Trajektorie wird die diskrete Lage des Fahrzeugs entlang der Trajektorie verwendet, um Abtastpunkte zu berechnen, die interpoliert werden.

Es werden die Eckpunkte, d. h. die äußersten Punkte, des Fahrzeugs herangezogen, um für eine gegebene Position entlang des Verlaufs der Ecke, die am meisten vorsteht, eine Berechnung vorzunehmen.

Die Diskretisierung der Fahrzeugtrajektorie setzt der Genauigkeit der Berechnung Grenzen. Die Eckpunkte des Fahrzeugs müssen bei jeder diskreten Fahrzeuglage transformiert werden, um die Position an dem gegebenen Punkt zu erhalten.

Wenn die Genauigkeitsanforderungen steigen, erhöht sich mit der geforderten Genauigkeit der Rechenaufwand, da mehr Transformationen notwendig sind.

### ZUSAMMENFASSUNG DER ERFINDUNG

Es kann ein Bedarf bestehen, eine Vorrichtung und Verfahren zum Berechnen von Belegungsflächen und -korridoren für ein Fahrzeug zu verbessern.

Diesen Bedarfen wird durch den Gegenstand der unabhängigen Ansprüche entsprochen. Weitere Ausführungsbeispiele sind den abhängigen Ansprüchen und der folgenden Beschreibung zu entnehmen.

Ein Aspekt der vorliegenden Erfindung betrifft eine Vorrichtung zur geometrischen Konstruktion einer vorhergesagten durch ein Fahrzeug belegten Fläche, wobei die Vorrichtung umfasst: eine Trajektoriezuordnungseinheit, die dazu ausgestaltet ist, basierend auf einer Liste von Fahrzeugscheitelpunkten, die jeweils eine Position und eine Bewegungsrichtung eines Punkts einer Karosserie eines Fahrzeugs definieren, eine Fahrzeugtrajektorie bereitzustellen;
eine Trajektorietransformationseinheit, die dazu ausgestaltet ist, eine Liste von Scheitelpunkten der äußersten Punkte zu berechnen, indem sie für eine gegebene Position des Fahrzeugs einen Punkt der Karosserie mit dem kleinsten und/oder dem größten Wenderadius auswählt, und die dazu ausgestaltet ist, basierend auf der Liste von Scheitelpunkten der äußersten Punkte des Fahrzeugs mehrere Eckentrajektorien bereitzustellen; und eine Lückenausräumeinheit und eine Schnittpunktentfernungseinheit, die dazu ausgestaltet sind, basierend auf den mehreren Eckentrajektorien einen Belegungskorridor bereitzustellen, wobei die Lückenausräumeinheit dazu ausgestaltet ist, aufeinanderfolgende Kurven der mehreren Eckentrajektorien zu verbinden, und wobei die Schnittpunktentfernungseinheit dazu ausgestaltet ist, sich schneidende Kurven der mehreren Eckentrajektorien abzuschneiden.

Das vorliegende Verfahren löst das Problem des Berechnens des Belegungskorridors mit diskreten Punkten durch Transformieren der nicht diskreten Kurventrajektorie des Fahrzeugs. Die Trajektorie der Ecken wird als Kurven berechnet, die ihrerseits die Anzahl der notwendigen Transformationen auf ein Minimum beschränken.

Das vorliegende Verfahren kann als Verfahren zur geometrischen Konstruktion einer vorhergesagten durch ein Fahrzeug belegten Fläche, zur Visualisierung basierend auf einer optimalen Spline-Kurven-Annäherung sowie einer spline-basierten Trajektorieoptimierung, für autonome Fahrzeuge mit Ackermann-Antrieb oder Ackermann-Lenkgeometrie verwendet werden.

Ein weiterer, zweiter Aspekt der vorliegenden Erfindung betrifft ein Verfahren zur geometrischen Konstruktion einer vorhergesagten durch ein Fahrzeug belegten Fläche, wobei das Verfahren folgende Schritt umfasst: Bereitstellen einer Fahrzeugtrajektorie basierend auf einer Liste von Fahrzeugscheitelpunkten, die jeweils eine Position und eine Bewegungsrichtung eines Punkts einer Karosserie eines Fahrzeugs definieren, mittels einer Trajektoriezuordnungseinheit; Berechnen einer Liste von Scheitelpunkten der äußersten Punkte durch Auswählen eines Punkts der Karosserie mit dem kleinsten und/oder dem größten Wenderadius für eine gegebene Position des Fahrzeugs mittels einer Trajektorietransformationseinheit und Bereitstellen mehrerer Eckentrajektorien basierend auf der Liste von Scheitelpunkten der äußersten Punkte des Fahrzeugs mittels der Trajektorietransformationseinheit; Bereitstellen eines Belegungskorridors basierend auf den mehreren Eckentrajektorien mittels einer Lückenausräumeinheit und einer Schnittpunktentfernungseinheit durch Verbinden aufeinanderfolgender Kurven der mehreren Eckentrajektorien; und durch Abschneiden sich schneidender Kurven der mehreren Eckentrajektorien.

Gemäß einem Ausführungsbeispiel der vorliegenden Erfindung ist die Schnittpunktentfernungseinheit dazu ausgestaltet, sich schneidende Kurven der mehreren Eckentrajektorien abzuschneiden, durch Abschneiden der sich schneidenden Kurven am Schnittpunkt unter Erhaltung des Teils, der nach außen gerichtet ist.

Gemäß einem Ausführungsbeispiel der vorliegenden Erfindung ist die Trajektorietransformationseinheit dazu ausgestaltet, die Liste von Scheitelpunkten der äußersten Punkte für alle Abschnitte der Fahrzeugtrajektorie zu berechnen.

Gemäß einem Ausführungsbeispiel der vorliegenden Erfindung ist die Trajektoriezuordnungseinheit dazu ausgestaltet, die Fahrzeugtrajektorie als Spline-Kurve bereitzustellen.

Gemäß einem Ausführungsbeispiel der vorliegenden Erfindung sind die Lückenausräumeinheit und die Schnittpunktentfernungseinheit dazu ausgestaltet, den Belegungskorridor basierend auf wenigstens zwei durchgehenden Kurven bereitzustellen, die auf den mehreren Eckentrajektorien basieren.

Ein Computerprogramm, welches das erfindungsgemäße Verfahren durchführt, kann auf einem computerlesbaren Medium gespeichert sein. Ein computerlesbares Medium kann eine Diskette, eine Festplatte, eine CD, eine DVD, eine *USB*(*Universal Serial Bus*)-Speichervorrichtung, ein RAM (*Random Access Memory -* Direktzugriffsspeicher), ein ROM (*Read Only Memory* - Nur-Lese-Speicher) oder ein EPROM (*Erasable Programmable Read Only Memory* - löschbarer programmierbarer Nur-Lese-Speicher) sein.

Ein computerlesbares Medium kann auch ein Datenkommunikationsnetzwerk, beispielsweise das Internet, sein, das ein Herunterladen eines Programmcodes gestattet.

Die Verfahren, Systeme und Vorrichtungen, die hierin beschrieben werden, können als Software in einem digitalen Signalprozessor, *Digital Signal Processor* - DSP, in einem Mikrocontroller oder in einem anderen Nebenprozessor oder als Hardwareschaltung im Rahmen einer anwendungsspezifischen integrierten Schaltung, *application specific integrated circuit* - ASIC, CPLD oder FPGA realisiert sein.

Die vorliegende Erfindung kann in einer digitalen elektronischen Schaltungsanordnung oder in Computerhardware, -firmware, -software oder in Kombinationen derselben realisiert sein, beispielsweise in verfügbarer Hardware herkömmlicher medizinischer Bildgebungsvorrichtungen oder in neuer Hardware, die eigens für eine Durchführung der hierin beschriebenen Verfahren konzipiert ist.

### KURZE BESCHREIBUNG DER ZEICHNUNGEN

Ein umfassenderes Verständnis der Erfindung und der damit einhergehenden Vorteile ergibt sich gewiss durch Bezugnahme auf die folgenden schematischen Zeichnungen, die nicht maßstabsgetreu sind, in denen:
- Fig. 1: zeigt eine Fahrzeugtrajektorie, die als Spline-Kurve dargestellt ist, gemäß einem Ausführungsbeispiel der vorliegenden Erfindung;
- Fig. 2: zeigt eine nicht diskrete Transformation von Eckpunkten gemäß einem Ausführungsbeispiel der vorliegenden Erfindung;
- Fig. 3: zeigt die vorgeschlagene Herangehensweise einer Transformation, die für alle Abschnitte der Fahrzeugtrajektorie erfolgt, gemäß einem Ausführungsbeispiel der vorliegenden Erfindung;
- Fig. 4: zeigt die vorgeschlagene Herangehensweise, gemäß der, nach Beseitigen von Schnittpunkten und Zwischenräumen, im Ergebnis eine durchgehende, ununterbrochene Kurve bereitgestellt wird, gemäß einem Ausführungsbeispiel der vorliegenden Erfindung;
- Fig. 5: zeigt eine schematische Darstellung der Vorrichtung zur geometrischen Konstruktion einer vorhergesagten durch ein Fahrzeug belegten Fläche gemäß einem Ausführungsbeispiel der vorliegenden Erfindung;
- Fig. 6: zeigt ein schematisches Ablaufdiagramm des Verfahrens zur geometrischen Konstruktion einer vorhergesagten durch ein Fahrzeug belegten Fläche gemäß einem Ausführungsbeispiel der vorliegenden Erfindung; und
- Fig. 7: zeigt eine Skizze einer möglichen Visualisierung des berechneten Korridors, so wie in dem Rundumansichtprojekt verwendet.

### DETAILLIERTE BESCHREIBUNG VON AUSFÜHRUNGSFORMEN

Die Darstellung in den Zeichnungen ist rein schematisch und soll keine maßstäblichen Beziehungen oder Größeninformationen bereitstellen. In unterschiedlichen Zeichnungen sind ähnliche oder gleiche Elemente mit den gleichen Bezugszeichen versehen.

Allgemein sind gleiche Teile, Einheiten, Gebilde oder Schritte in der Beschreibung mit den gleichen Bezugszeichen versehen.

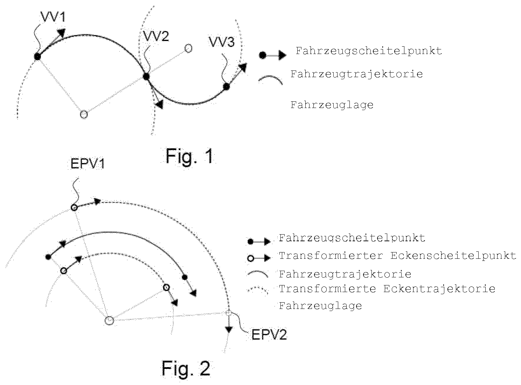

Fig. 1 zeigt eine Fahrzeugtrajektorie, die als Spline-Kurve dargestellt ist, gemäß einem Ausführungsbeispiel der vorliegenden Erfindung.
Fig. 2 zeigt eine nicht diskrete Transformation von Eckpunkten gemäß einem Ausführungsbeispiel der vorliegenden Erfindung.

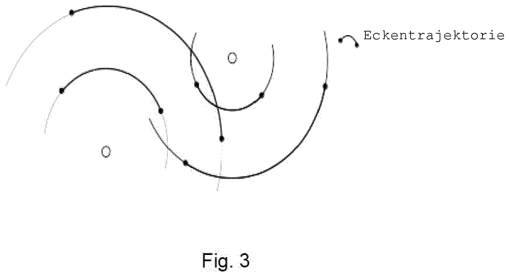

Fig. 3 zeigt die vorgeschlagene Herangehensweise einer Transformation, die für alle Abschnitte der Fahrzeugtrajektorie erfolgt, gemäß einem Ausführungsbeispiel der vorliegenden Erfindung.

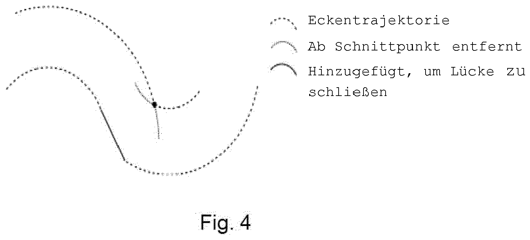

Fig. 4 zeigt die vorgeschlagene Herangehensweise, gemäß der, nach Beseitigen von Schnittpunkten und Zwischenräumen, im Ergebnis eine durchgehende, ununterbrochene Kurve bereitgestellt wird, gemäß einem weiteren Ausführungsbeispiel der vorliegenden Erfindung.

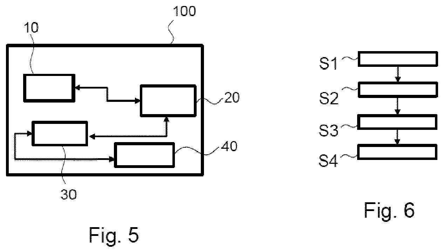

Fig. 5 zeigt eine schematische Darstellung der Vorrichtung zur geometrischen Konstruktion einer vorhergesagten durch ein Fahrzeug belegten Fläche gemäß einem Ausführungsbeispiel der vorliegenden Erfindung.

Die Vorrichtung 100 zur geometrischen Konstruktion einer vorhergesagten durch ein Fahrzeug belegten Fläche umfasst eine Trajektoriezuordnungseinheit 10, eine Trajektorietransformationseinheit 20, eine Lückenausräumeinheit 30 und eine Schnittpunktentfernungseinheit 40.

Die Trajektoriezuordnungseinheit 10 ist dazu ausgestaltet, basierend auf einer Liste von Fahrzeugscheitelpunkten VV1, VV2, VV3, ..., VVn, die jeweils eine Position und eine Bewegungsrichtung eines Punkts VBP einer Karosserie VB eines Fahrzeugs V definieren, eine Fahrzeugtrajektorie bereitzustellen.

Die Trajektoriezuordnungseinheit 10 kann dazu ausgestaltet sein, die Liste von Fahrzeugscheitelpunkten VV1, VV2, VV3, ..., VVn von externen Vorrichtungen oder Anbietern zu empfangen. Die Trajektoriezuordnungseinheit 10 kann eine Schnittstelle oder ein Kommunikationssystem umfassen, um Daten bezüglich der Liste von Fahrzeugscheitelpunkten zu empfangen.

Die Trajektorietransformationseinheit 20 ist dazu ausgestaltet, eine Liste von Scheitelpunkten der äußersten Punkte EPV1, EPV2, EPV3, ..., EPVn zu berechnen, indem sie für eine gegebene Position des Fahrzeugs einen Punkt VBP der Karosserie VB mit dem kleinsten und/oder dem größten Wenderadius auswählt, und ist dazu ausgestaltet, basierend auf der Liste von Scheitelpunkten der äußersten Punkte EPV1, EPV2, EPV3, ..., EPVn des Fahrzeugs V mehrere Eckentrajektorien bereitzustellen.

Die Lückenausräumeinheit 30 und die Schnittpunktentfernungseinheit 40 sind dazu ausgestaltet, basierend auf den mehreren Eckentrajektorien einen Belegungskorridor bereitzustellen, wobei die Lückenausräumeinheit 30 dazu ausgestaltet ist, aufeinanderfolgende Kurven der mehreren Eckentrajektorien zu verbinden, und wobei die Schnittpunktentfernungseinheit 40 dazu ausgestaltet ist, sich schneidende Kurven der mehreren Eckentrajektorien abzuschneiden.

Fig. 6 zeigt eine schematische Darstellung des Verfahrens zur geometrischen Konstruktion einer vorhergesagten durch ein Fahrzeug belegten Fläche gemäß einem Ausführungsbeispiel der vorliegenden Erfindung.

Das Verfahren zur geometrischen Konstruktion einer vorhergesagten durch ein Fahrzeug belegten Fläche umfasst folgende Schritte:

Als erster Schritt des Verfahrens kann ein Bereitstellen S1 einer Fahrzeugtrajektorie basierend auf einer Liste von Fahrzeugscheitelpunkten VV1, VV2, VV3, ..., VVn, die jeweils eine Position und eine Bewegungsrichtung eines Punkts VBP einer Karosserie VB eines Fahrzeugs V definieren, mittels einer Trajektoriezuordnungseinheit 10 durchgeführt werden.

Als zweiter Schritt des Verfahrens kann ein Berechnen S2 einer Liste von Scheitelpunkten der äußersten Punkte EPV1, EPV2, EPV3, ..., EPVn durch Auswählen eines Punkts VBP der Karosserie VB mit dem kleinsten und/oder dem größten Wenderadius für eine gegebene Position des Fahrzeugs mittels einer Trajektorietransformationseinheit 20 durchgeführt werden.

Ferner kann mittels der Trajektorietransformationseinheit 20 ein Bereitstellen mehrerer Eckentrajektorien basierend auf der Liste von Scheitelpunkten der äußersten Punkte EPV1, EPV2, EPV3, ..., EPVn des Fahrzeugs V durchgeführt werden.

Ferner kann mittels einer Lückenausräumeinheit 30 und mittels einer Schnittpunktentfernungseinheit 40 ein Bereitstellen eines Belegungskorridors basierend auf den mehreren Eckentrajektorien durchgeführt werden.

Als dritter Schritt des Verfahrens kann ein Verbinden S3 aufeinanderfolgender Kurven der mehreren Eckentrajektorien durchgeführt werden.

Als vierter Schritt des Verfahrens kann ein Abschneiden S4 sich schneidender Kurven der mehreren Eckentrajektorien durchgeführt werden.

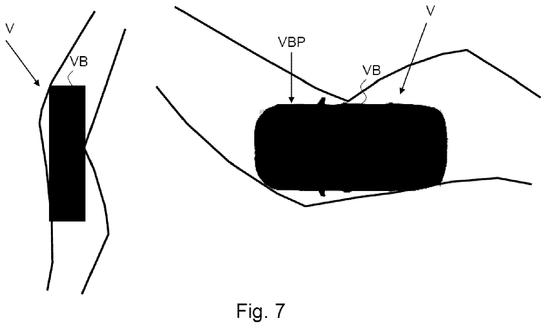

Fig. 7 zeigt eine Skizze einer möglichen Visualisierung des berechneten Korridors, so wie in dem Rundumansichtprojekt verwendet. Die Trajektorie, die als Grundlage dient, stammt aus einer realen Parksituation.

Fig. 7 zeigt eine Bewegungsrichtung eines Punkts VBP - z. B. eines bestimmten Punkts des Fahrzeugpunkts, beispielsweise der Oberseite des rechten Flügels - einer Karosserie VB eines Fahrzeugs V.

Man beachte, dass Ausführungsformen der vorliegenden Erfindung unter Bezugnahme auf unterschiedliche Gegenstände beschrieben werden. Insbesondere werden einige Ausführungsformen unter Bezugnahme auf Verfahrensansprüche beschrieben, wohingegen andere Ausführungsformen unter Bezugnahme auf die Vorrichtungsansprüche beschrieben werden.

Der Fachmann wird jedoch dem oben Gesagten und der vorstehenden Beschreibung entnehmen, dass, sofern nicht anders angegeben, zusätzlich zu jeder Kombination von Merkmalen, die zu einer Art des Gegenstands gehören, auch jede Kombination von Merkmalen, die unterschiedliche Gegenstände betreffen, als mit dieser Anmeldung offenbart angesehen wird.

Es können jedoch alle Merkmale kombiniert werden und so Synergieeffekte bereitgestellt werden, die mehr sind als die einfache Summierung dieser Merkmale.

Auch wenn die Erfindung in den Zeichnungen und der vorstehenden Beschreibung ausführlich dargestellt und beschrieben wurde, so sind diese Darstellung und Beschreibung als veranschaulichend oder beispielhaft und nicht einschränkend anzusehen; die vorliegende Erfindung ist nicht auf die offenbarten Ausführungsformen beschränkt.

Andere Abwandlungen der offenbarten Ausführungsformen erschließen sich dem Fachmann, der die beanspruchte Erfindung praktiziert, im Zuge einer Durchsicht der Zeichnungen, der Offenbarung und der angefügten Ansprüche und können durch diesen umgesetzt werden.

In den Ansprüchen schließt das Wort "umfassend" andere Elemente oder Schritte nicht aus, und der unbestimmte Artikel "ein" oder "eine" schließt eine Mehrzahl nicht aus. Ein(e) einzige(r) Prozessor oder Controller oder andere Einheit kann die Funktionen mehrerer in den Ansprüchen genannter Gegenstände erfüllen.

Die bloße Tatsache, dass bestimmte Maßnahmen in voneinander verschiedenen abhängigen Ansprüchen genannt sind, zeigt nicht an, dass eine Kombination dieser Maßnahmen nicht vorteilhaft verwendet werden kann. Bezugszeichen in den Ansprüchen sollten nicht als den Schutzbereich einschränkend angesehen werden.

## Patentansprüche

1. Vorrichtung (100) zur geometrischen Konstruktion einer vorhergesagten durch ein Fahrzeug belegten Fläche, wobei die Vorrichtung (100) umfasst:
eine Trajektoriezuordnungseinheit (10), die dazu ausgestaltet ist, basierend auf einer Liste von Fahrzeugscheitelpunkten (VV1, VV2, VV3, ..., VVn), die jeweils eine Position und eine Bewegungsrichtung eines Punkts (VBP) einer Karosserie (VB) eines Fahrzeugs (V) definieren, eine Fahrzeugtrajektorie bereitzustellen;
eine Trajektorietransformationseinheit (20), die dazu ausgestaltet ist, eine Liste von Scheitelpunkten der äußersten Punkte (EPV1, EPV2, EPV3, ..., EPVn) zu berechnen, indem sie für eine gegebene Position des Fahrzeugs einen Punkt (VBP) der Karosserie (VB) mit dem kleinsten und/oder dem größten Wenderadius auswählt, und die dazu ausgestaltet ist, basierend auf der Liste von Scheitelpunkten der äußersten Punkte (EPV1, EPV2, EPV3, ..., EPVn) des Fahrzeugs (V) mehrere Eckentrajektorien bereitzustellen; und
eine Lückenausräumeinheit (30) und eine Schnittpunktentfernungseinheit (40), die dazu ausgestaltet sind, basierend auf den mehreren Eckentrajektorien einen Belegungskorridor bereitzustellen, wobei die Lückenausräumeinheit (30) dazu ausgestaltet ist, aufeinanderfolgende Kurven der mehreren Eckentrajektorien zu verbinden, und wobei die Schnittpunktentfernungseinheit (40) dazu ausgestaltet ist, sich schneidende Kurven der mehreren Eckentrajektorien abzuschneiden.

2. Vorrichtung (100) nach Anspruch 1,
wobei die Schnittpunktentfernungseinheit (40) dazu ausgestaltet ist, sich schneidende Kurven der mehreren Eckentrajektorien abzuschneiden, durch Abschneiden der sich schneidenden Kurven am Schnittpunkt unter Erhaltung des Teils, der nach außen gerichtet ist.

3. Vorrichtung nach Anspruch 1 oder 2,
wobei die Trajektorietransformationseinheit (20) dazu ausgestaltet ist, die Liste von Scheitelpunkten der äußersten Punkte (EPV1, EPV2, EPV3, ..., EPVn) für alle Abschnitte der Fahrzeugtrajektorie zu berechnen.

4. Vorrichtung nach einem der vorangehenden Ansprüche,
wobei die Trajektoriezuordnungseinheit (10) dazu ausgestaltet ist, die Fahrzeugtrajektorie als Spline-Kurve bereitzustellen.

5. Vorrichtung nach einem der vorangehenden Ansprüche,
wobei die Lückenausräumeinheit (30) und die Schnittpunktentfernungseinheit (40) dazu ausgestaltet sind, den Belegungskorridor basierend auf wenigstens zwei durchgehenden Kurven bereitzustellen, die auf den mehreren Eckentrajektorien basieren.

6. Verfahren zur geometrischen Konstruktion einer vorhergesagten durch ein Fahrzeug belegten Fläche, wobei das Verfahren folgende Schritte umfasst:
- Bereitstellen (S1) einer Fahrzeugtrajektorie basierend auf einer Liste von Fahrzeugscheitelpunkten (VV1, VV2, VV3, ..., VVn), die jeweils eine Position und eine Bewegungsrichtung eines Punkts (VBP) einer Karosserie (VB) eines Fahrzeugs (V) definieren, mittels einer Trajektoriezuordnungseinheit (10);
- Berechnen (S2) einer Liste von Scheitelpunkten der äußersten Punkte (EPV1, EPV2, EPV3, ..., EPVn) durch Auswählen eines Punkts (VBP) der Karosserie (VB) mit dem kleinsten und/oder dem größten Wenderadius für eine gegebene Position des Fahrzeugs mittels einer Trajektorietransformationseinheit (20) und Bereitstellen mehrerer Eckentrajektorien basierend auf der Liste von Scheitelpunkten der äußersten Punkte (EPV1, EPV2, EPV3, ..., EPVn) des Fahrzeugs (V) mittels der Trajektorietransformationseinheit (20);
- Bereitstellen eines Belegungskorridors basierend auf den mehreren Eckentrajektorien mittels einer Lückenausräumeinheit (30) und einer Schnittpunktentfernungseinheit (40) durch
- Verbinden (S3) aufeinanderfolgender Kurven der mehreren Eckentrajektorien; und durch
- Abschneiden (S4) sich schneidender Kurven der mehreren Eckentrajektorien.

7. Verfahren nach Anspruch 6,
umfassend den Schritt eines Abschneidens sich schneidender Kurven der mehreren Eckentrajektorien durch Abschneiden der sich schneidenden Kurven am Schnittpunkt unter Erhaltung des Teils, der nach außen gerichtet ist.

8. Verfahren nach Anspruch 6 oder 7,
umfassend den Schritt eines Berechnens der Liste von Scheitelpunkten der äußersten Punkte (EPV1, EPV2, EPV3, ..., EPVn) für alle Abschnitte der Fahrzeugtrajektorie.

9. Verfahren nach einem der vorangehenden Ansprüche,
umfassend den Schritt eines Berechnens der Fahrzeugtrajektorie als Spline-Kurve.
